# EUROPEAN PATENT SPECIFICATION

(11) **EP 2 509 217 B1**
(45) Date of publication and mention of the grant of the patent: **25.12.2013**
(21) Application number: 11290176.4
(22) Date of filing: 07.04.2011
(51) Int. Cl.: H03F 3/191, H03F 13/00

(54) **Method for amplifying an RF signal and tuneable RF power amplifier device**
Verfahren zur Verstärkung eines Hochfrequenzsignals und abstimmbare Leistungsverstärkungsvorrichtung
Procédé pour amplifier un signal RF et dispositif amplificateur de puissance RF

(43) Date of publication of application: 10.10.2012
(73) Proprietor: Alcatel Lucent, 75007 Paris (FR)
(72) Inventor: Templ, Wolfgang, 74372 Sersheim (DE); Wiegner, Dirk, 71409 Schwaikheim (DE)
(74) Representative: Wetzel, Emmanuelle

(56) References cited:
- EP-A1- 2 312 749
- GB-A- 1 481 591
- US-A- 3 413 573
- US-A- 3 739 290
- GIANLUCA PIAZZA ET AL: "AlN Contour-Mode Vibrating RF MEMS for Next Generation Wireless Communications", SOLID-STATE DEVICE RESEARCH CONFERENCE, 2006. ESSDERC 2006. PROCEEDING OF THE 36TH EUROPEAN, IEEE, PI, 1 September 2006 (2006-09-01), pages 61-64, XP031046993, ISBN: 978-1-4244-0301-1
- JEAN-PIERRE RASKIN ET AL: "A Novel Parametric-Effect MEMS Amplifier", JOURNAL OF MICROELECTROMECHANICAL SYSTEMS, IEEE SERVICE CENTER, PISCATAWAY, NJ, US, vol. 9, no. 4, 1 December 2000 (2000-12-01), XP011034596, ISSN: 1057-7157
- REICHENBACH R B ET AL: "A MEMS RF phase and frequency modulator", SOLID-STATE SENSORS, ACTUATORS AND MICROSYSTEMS, 2005. DIGEST OF TECHN ICAL PAPERS. TRANSDUCERS '05. THE 13TH INTERNATIONAL CONFERENCE ON SEOUL, KOREA JUNE 5-9, 2005, PISCATAWAY, NJ, USA,IEEE, vol. 1, 5 June 2005 (2005-06-05), pages 1059-1062, XP010828102, DOI: 10.1109/SENSOR.2005.1496638 ISBN: 978-0-7803-8994-6

## Description

### Field of the invention

The invention relates to a method for providing an amplified RF signal, to a tuneable RF power amplifier device, and to a base station comprising the same.

### Background

This section introduces aspects that may be helpful in facilitating a better understanding of the invention. Accordingly, the statements of this section are to be read in this light and are not to be understood as admissions about what is in the prior art or what is not in the prior art.

Wireless communication systems of the 3rd generation ("3G") and later use modulation formats which yield RF (radio frequency) output signals featuring high peak to average ratios. The amplification of such signals imposes high requirements on power efficiency and linearity to the transmitter line up, especially for the final stage of the RF power amplifier, where by far the largest share of energy is dissipated.

Unpublished European patent application 09 290 788.0 describes an amplification method wherein an amplified signal is constructed by stimulating coupling elements such as overlapping reeds at their resonance frequencies in dependence of the spectral components ("frequency bins") of a signal to be amplified (basic HARP concept). The RF output signal is generated by composing its frequency components generated by means of nano-sized coupling elements, which act as mechanical oscillators at their resonance frequency each. When excited, each coupling element oscillates at its resonance frequency, and via the change of its coupling during an oscillation, the corresponding frequency component can be generated by modulating an externally applied supply voltage (providing electric power). This results in an inherent frequency-up conversion. The exploitation of the self-resonance of the nano-sized coupling elements in the inventive coupling arrays allows for a completely different and disruptive approach for realization of a high efficient RF amplifier: The output signal is generated by the combination of spectral signal components which are generated by the controlled triggered self oscillations of nano-sized coupling elements ("switches"). Those coupling elements are grouped in a number of sub-arrays, characterized by specific physical parameters (geometrical dimension, material, suspension) of their coupling elements, wherein the physical parameters define the self resonance at a well defined frequency and attenuation. All coupling elements of the same sub-array have the same resonance frequency and the same attenuation, within the limits of the manufacturing tolerance. Thus, a concept for a highly efficient and linear RF power amplifier of small form factor which already includes frequency up-conversion is provided.

In order to result in the desired output signal the resonant frequencies of the coupling elements have to fit to the frequency components of the RF signal to be amplified. Thus, it is desirable to assign a defined resonance frequency to the coupling elements of each sub-array.

The self oscillation frequency of each individual reed is largely defined by its physical properties, i.e. its material properties, geometrical dimensions and temperature. Due to changes in temperature or due to aging of the coupling elements the resonant frequencies of the coupling elements may vary, which results in an output signal of reduced quality.

### Object of the Invention

It is an object of the invention to provide a method for providing an amplified RF signal and an RF power amplifier device which allow to reach a desired signal frequency distribution and to compensate for temperature drift and aging of the coupling elements, possibly allowing to implement a multi-band RF power amplifier device.

### Summary of the Invention

The present invention is directed to addressing the effects of one or more of the problems set forth above. The following presents a simplified summary of the invention in order to provide a basic understanding of some aspects of the invention. This summary is not an exhaustive overview of the invention. It is not intended to identify key or critical elements of the invention or to delineate the scope of the invention. Its sole purpose is to present some concepts in a simplified form as a prelude to the more detailed description that is discussed later.

One aspect of the invention relates to a method for providing an amplified RF signal which comprises the steps of
- analysing the spectral components, namely the amplitudes and the phases at different frequencies, of a signal to be amplified,
- applying a supply voltage, in particular a dc supply voltage, to a coupling array comprising a plurality of nano-sized coupling elements, wherein the coupling elements are grouped into a number N of sub-arrays, with each sub-array exhibiting
   - a specific resonance frequency corresponding to a frequency component of the RF signal to be amplified, and
   - a specific attenuation
   of a mechanical self oscillation of its coupling elements,
- stimulating mechanical self-oscillations of the coupling elements of the sub-arrays in dependence of the spectral components of the signal to be amplified, wherein during and/or prior to the amplification, the resonance frequencies of the coupling elements of the sub-arrays are tuned to match the frequency components of the signal to be amplified.

The analysis of the spectral components of the signal to be amplified preferably comprises analysing the spectral components of a baseband signal to be up-converted to RF frequencies and amplified. In this case the stimulation of the coupling elements of the sub-arrays is carried out in dependence of the spectral components of the baseband signal. The RF signal is synthesized according to the information of the baseband signal.

According to the invention, the self oscillation frequencies of the coupling elements are tuned during and/or prior to the amplification process to match the frequency components of the RF signal to be amplified. For this purpose, the self oscillation frequency of each or some of the coupling elements may be tuned individually in a certain frequency interval, whereby coupling elements of the same sub-array are tuned to the same frequency.

The tuning is used for adapting the frequencies of the coupling elements to the spectral components of the RF signal to be amplified. Thus, the coupling elements are enabled to meet the required signal frequency distribution even in case of an unintended frequency shift due to aging or change in the temperature of the environment. In some cases, it may be sufficient to tune only a few of the coupling elements of a sub-array of the RF amplifier device, e.g. if only a part of the coupling elements of that sub-array are sufficient to meet the required frequency distribution.

Typically, the self oscillation frequencies of the individual coupling elements are tuned based on the requirements of the desired output signal. Accordingly, the coupling elements can be tuned to achieve best linearity performance and to match the required output spectrum. The inventive method supports improved yield and performance and can thus contribute to reduced cost and an improved realisation of the HARP concept. Moreover, the tuneable frequency range of the coupling elements may be chosen so large that a tuneable dual- or multi-band amplifier may be implemented, e.g. between 1.8 GHz and 2.1 GHz. Such a reconfigurable multi-band capability may be advantageously used to support SDR.

In a preferred variant, the tuning is carried out by preferably reversibly modifying the geometrical dimensions of the coupling elements by means of tuning devices. By controlled modification of the geometrical dimensions of the coupling elements, the resonance frequencies of the coupling elements can be adapted in dependence of a desired output spectrum. It will be understood that typically the geometrical dimensions of the coupling elements are modified in a reversible manner.

In a preferred variant, the modification of the geometrical dimensions of the coupling elements is done by applying an electric field, by irradiating the coupling elements with light and/or by heating the coupling elements. In this way, the modification of the geometrical dimensions can be realized e.g. due to thermal excitation, electrostriction or photostriction. A magnetic field may be applied as well, providing a modification of the geometrical dimensions using magnetostriction.

The inventive method preferably comprises the steps of:
a) feeding back a sample of the amplified RF signal,
b) comparing the sample of the amplified RF signal to a desired RF output signal,
c) if a difference between the desired RF output signal and the sample of the amplified RF signal exceeds a pre-defined threshold, modifying the geometrical dimensions of the coupling elements by means of at least one tuning device, and
d) repeating steps a) - c) until the difference between the desired RF output signal and the sample of the amplified RF signal does not exceed the pre-defined threshold.

By providing feedback using a sample of an actual amplified RF output signal, i.e. of the output signal at a selected point of time, the coupling elements may be tuned based on desired properties of the output signal, in order to match e.g. a required output spectrum and/or to achieve best linearity performance.

The comparison is preferably done by comparing the spectral components of the sample of the amplified RF signal to the corresponding spectral components of desired RF output signal. This facilitates identification of the sub-arrays which have to be tuned.

A further aspect of the invention relates to a (tuneable) RF power amplifier device, comprising:
- a coupling array comprising a plurality of nano-sized coupling elements for generating frequency components of an RF output signal, wherein the coupling elements are grouped into a number N of sub-arrays, with each sub-array exhibiting
   - a specific resonance frequency and
   - a specific attenuation
   of a mechanical self-oscillation of its coupling elements,
   wherein for the coupling elements of each sub-array, there is a stimulating means for stimulating a mechanical self-oscillation,
- and a signal processing unit for controlling the stimulating means with stimulating pulses having a pulse form and timing calculated by the signal processing unit based on an evaluation of the spectral components of a signal to be amplified, namely the amplitudes and phases at the frequencies corresponding to said specific resonance frequencies. According to the invention, tuning devices for tuning the resonance frequencies of the coupling elements of the sub-arrays are provided, wherein the signal processing unit is adapted to control the tuning devices.

The inventive RF power amplifier device can be used for amplifying and D/A conversion, rendering up-mixing unnecessary.

Each tuning device may be associated with one of the sub-arrays in order to tune the coupling elements of the corresponding sub-array individually to a desired frequency. In this way, the inventive RF amplifier device allows for improving spectral signal quality and leads to improved broadband or even multiband capability (depending on the achievable frequency tuning range), compared to the basic HARP concept.

Advantageously, the tuning devices comprise means for modifying the geometrical dimensions, in particular the length, of the coupling elements. By modifying the geometrical dimensions, the resonance frequency may be varied easily. There is a variety of possibilities how to realise the inventive modification of the geometrical dimensions of the coupling elements, some of which are described below.

In a preferred embodiment of the inventive RF power amplifier device, at least one, preferably each coupling element of at least one sub-array comprises a heater layer and the corresponding tuning device comprises a heating device for heating the heater layer of the coupling element. The geometrical dimension and thus the resonance frequency of the coupling device varies in dependence of the temperature of the heater layer. The heating may be realized by supplying a current to the heater layer by application of a voltage to two opposite ends of the heater layer or in another way, e.g. by induction. Instead of a heater layer a cooling layer can be used which is cooled by a cooling device. Cooling and heating can be realized e.g. by using a heat exchanger.

Alternatively or additionally, at least one, preferably each, coupling element of at least one sub-array comprises a dielectric layer of electrostrictive material and the corresponding tuning device comprises means for applying an electric field to the dielectric layer of the coupling element. In this case, deformation of the coupling element is realized by electrostriction, which causes the coupling element (more precisely the dielectric layer) to change shape under the application of an electric field. The resonance frequency of the coupling element varies according to the applied electric field.

Alternatively or additionally, at least one, preferably each, coupling element of at least one sub-array comprises a layer of photostrictive material and the corresponding tuning device comprises a light source for irradiating the ceramic layer of the coupling element. In this case, deformation is realized due to photostriction, which causes the coupling element (more precisely the ceramic layer) to change shape due to irradiation with light.

A preferred embodiment of the inventive RF power amplifier device comprises a feedback loop for feeding back a sample of the amplified RF signal to the signal processing unit, wherein the signal processing unit is adapted to compare the sample of the amplified RF signal to a desired RF output signal, and to modify the geometrical dimensions of the coupling elements for minimizing a difference between the sample of the amplified RF signal and the desired RF output signal.

In this way, the resonance frequencies of the coupling elements can be adapted in order to provide consistency between the actual output signal and the desired output signal (which is an amplified reconstruction of the signal to be amplified).

Another aspect of the invention relates to a base station comprising at least one RF amplifier device as described above.

The inventive RF amplifier device is advantageously used in a software-defined radio (SDR) platform, cognitive radio (CR) platform, or in a common platform.

Further features and advantages are stated in the following description of exemplary embodiments, with reference to the figures of the drawing, which shows significant details, and are defined by the claims. The individual features can be implemented individually by themselves, or several of them can be implemented in any desired combination.

### Brief Description of the Drawings

Exemplary embodiments are shown in the diagrammatic drawing and are explained in the description below.
- **Fig. 1**: shows a schematic diagram of an embodiment of an inventive RF power amplifier device with tuning devices;
- **Fig. 2**: shows schematically a switching reed of the inventive RF power amplifier device of Fig. 1 comprising a heater layer; and
- Fig.3: shows a schematic diagram of an RF power amplifier device according to the basic HARP concept.

### Detailed Description of Preferred Embodiments

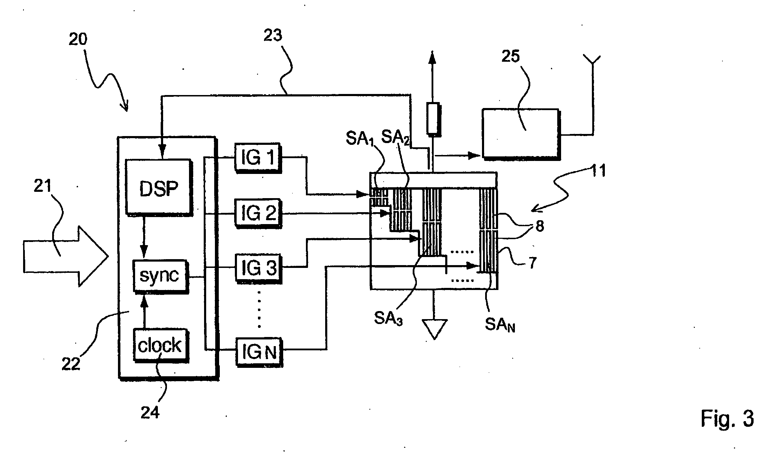

First, the basic operation of a RF power amplifier device 20 shown in fig. 3 will be explained. Note that the basic operation principle (including the function of most components) is also described in European patent application 09 290 788.0, the contents of which are herewith incorporated by reference.

Basically, an amplified RF signal is generated by supplying a supply voltage to a coupling array 11. Said coupling array 11 comprises a number N of sub-arrays **SA₁-SA_{N},** each comprising (in the present example) a number m of coupling elements 8 (note that for simplicity, only three coupling elements 8 per sub-array SA₁-SA_{N} are shown, but in practice, there are typically a hundred or more coupling elements per sub-array). The coupling elements 8 of each sub-array SA₁...SA_{N} have a specific resonance frequency (f₁...f_{N}) and a specific attenuation. In the example shown, each coupling element 8 consists of a pair of opposing reeds 7, the distance of which varies when the coupling element 8 is subjected to a mechanical self oscillation (note that other coupling elements, e.g. based on vibrating membranes or torsion oscillations of bar elements, are also possible, cf. European patent application 09 290 788.0). When the coupling elements 8 of a specific sub-array SA₁...SA_{N} oscillate (typically in phase), the coupling of the two sides of the coupling array 11 changes with the oscillation frequency (i.e. the specific resonance frequency), and an ac type current through the coupling array 11 with a spectral component (frequency component) corresponding to the specific frequency results. The mechanical self oscillations of the coupling elements 8 are induced by stimulating means, such as piezoelectric coatings on the reeds 7, as will be described further below.

The RF power amplifier device 20 comprises a signal processing unit 22, which receives baseband information 21 determining the spectral components (i.e. frequencies f₁ ... f_{N}, amplitudes C₁ ... C_{N} and phases Φ₁ ... Φ_{N}) of a signal (input signal) to be amplified.

With this spectral component information 21, the signal processing unit 22 calculates the pulse form and timing for stimulating pulses. In the example shown, this information is sent to stimulating impulse generators IG1...IGN, with one stimulating impulse generator IG1...IGN for each sub-array SA₁...SA_{N} of the coupling array 11. The stimulating impulse generators IGN create stimulating pulses for their respective sub-array SA_{N} each, based on the pulse form and timing information from the signal processing unit 22, i.e. the stimulating pulses are used to drive the stimulating means of the coupling elements 8.

The amplitude of the stimulating pulse determines the power of the spectral component and the timing determines its phasing. The calculation of the pulse form and timing is (in the present case) based on the spectral input information on baseband level, a fed back sample (see feedback path 23) of the RF output signal, and a reference clock 24. The resonance frequencies f₁...f_{N} of the coupling elements 8 within the sub-arrays SA₁...SA_{N} are fixed and ideally correspond to the frequencies f₁...f_{N} of the analyzed spectral components of the input signal. The amplified RF output signal is fed into an antenna network 25, which transmits the amplified RF output signal into the surroundings.

As an example, an RF power amplifier device 20 may apply a frequency resolution in equal steps of between 1 kHz and 50 kHz, with a typical width of a resolved frequency interval of between 1 MHz and 100 MHz. The centre frequency of the amplified RF signal is typically between 500 MHz and 10 GHz (note that the input signal is typically at baseband level). For example, with a frequency resolution of 50 kHz and a width of 100 MHz, the coupling array 11 comprises about 1000 sub-arrays, i.e. N=1000.

The amplifier principle shown in fig. 3 is a concept of a highly efficient transmitter, based on the idea to create the RF signal in a highly efficient way, based on the resonators, representing the required spectral parts ("frequency bins") of the RF signal to be transmitted. This is done on the knowledge of the baseband signal (signal to be amplified) and on the specific components of the coupling elements 8, like e.g. the reeds 7, managing the "up-conversion" by their related self oscillation frequency.

**Fig. 1** shows an embodiment of an RF amplifier device 10 according to the invention with a coupling array 11 comprising pairs of reeds 7 acting as coupling elements 8 in accordance with the aforementioned RF amplifier device 20 shown in fig. 3. The RF amplifier device 10 is capable of reversibly tuning the self oscillation frequency of the individual reeds 7 based on the requirements of the desired RF output signal. For this purpose, tuning devices T₁, ... , T_{N} are provided, preferably one for each sub-array SA₁ ... SAₙ. Yet, it is also possible to provide less than N tuning devices T₁ ... T_{N} in order to reduce cost, whereby only a selected number of sub-arrays SA₁ ... SA_{N} is provided with tuning devices.

In order to control the tuning devices T₁,...,T_{N}, the spectral quality of the output signal is analyzed based on a signal (originating from a sample of the output signal) which is fed back to the processing unit 22 via feedback line 23 and is compared to a (calculated) desired signal which is derived from the input baseband signal. The self oscillation frequency of the individual reeds 7 is controller based on the comparison of the feedback signal with the (calculated) desired output signal by the signal processing unit 22 which also stimulates the reeds 7. The processing unit 22 comprises a digital signal processor 26 which calculates the required tuning parameters. The tuning devices T₁,...,T_{N} are connected to the signal processing unit 22 which controls the tuning devices T₁, ..., T_{N} in order to achieve a desired output characteristic, for instance a best linearity performance and matching to the required output spectrum.

The tuning of the coupling elements 8, respectively of the reeds 7, may be performed in different ways, e.g. by applying an electric field to the coupling elements 8 and/or by irradiating the coupling elements 8 with light and/or by heating the coupling elements 8. In the following, a thermal tuning of the coupling elements 8 will be described. In this case, the digital signal processor 26 calculates the required heating power and controls the individual heating power supplies (tune 1.1 ...n.m) used for the thermal tuning.

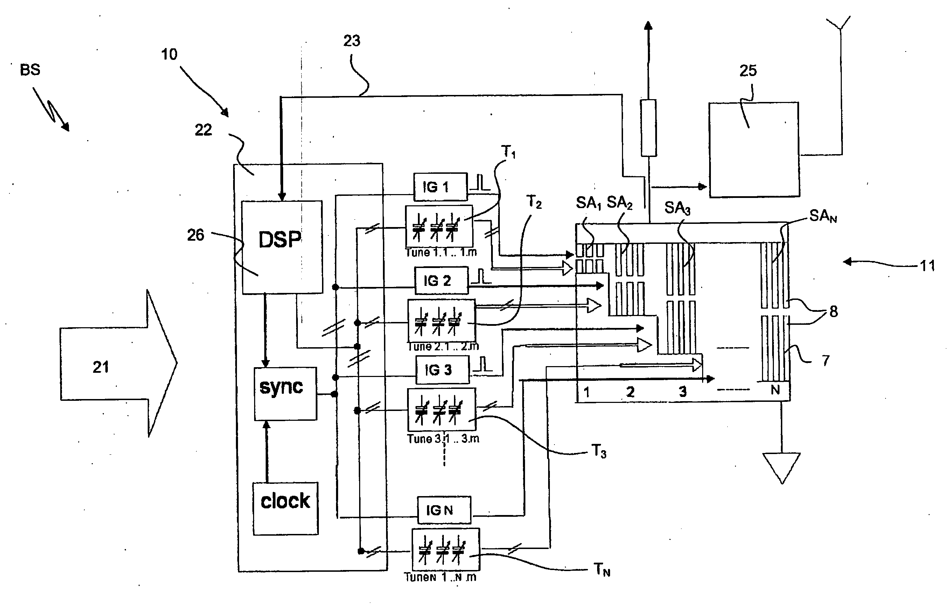

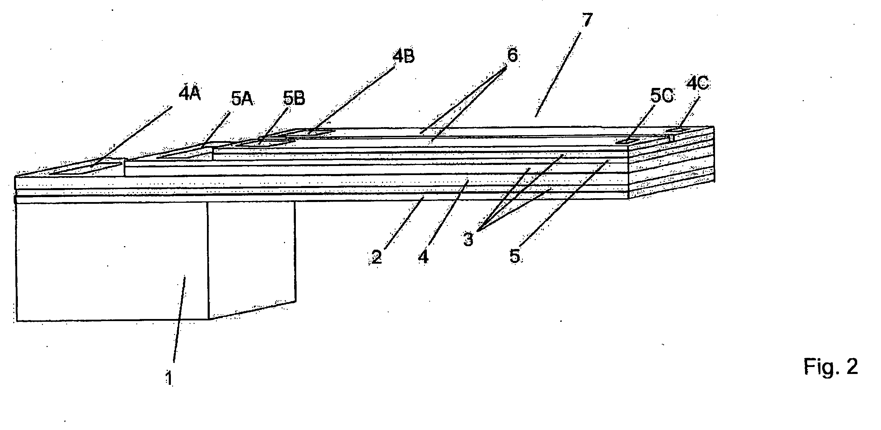

**Fig. 2** shows a layer structure (coating structure) of a single reed element 7, which can be tuned by thermal excitation. On a coupler contact **1,** the reed 7 is mounted at one (left) end; the other (right) end extends freely away from the coupler contact 1. The base structures of the reed 7 are a layer (or coating) supporting electron emission ("emission layer **2")** and a piezoactive layer (or coating) **4.** The emission layer 2 is directly attached to the coupler contact 1 to electrically connect the emission layer 2 to a voltage supply (not shown) and faces another partly overlapping reed (not shown). The emission layer 2 and the piezoactive layer 4 are separated by an insulating layer 3, such as an oxide layer. On top of the piezoactive layer 4, there is another insulating layer 3. The top layer of the reed 7 is a metallization **6.**

The piezoactive layer 4 may be electrically contacted at its left (exposed) end via a first piezo contact 4A at the rear end of the reed 7. At its right (covered) end, a second (window) contact 4C is provided at the front end of the reed 7 reaching through openings in the underlying layers to provide electrical contact with the piezoactive layer 4. The second (window) contact 4C is electrically connected via the metallization 6 to a metallization contact 4B in the region of the coupler contact 1 such that the areas of immediate connection to an external piezo voltage supply, namely the first contact 4A and the metallization contact 4C, are well reachable and are not exposed to deflection during a reed oscillation.

By applying a voltage pulse across the piezo-electric layer 4 (i.e. between the contacts 4A, 4C), the piezo-electric layer 4 may be contracted, whereas the emission layer 2 remains at its original length, resulting in an upward-bending of the reed 7 at its free right end. After the voltage application has ended, the reed 7 will oscillate at its resonance frequency, causing a coupling varying with the resonance frequency.

Note that the reed 7 may comprise an additional layer, in particular in order to deposit both the emission layer and the piezoactive layer as coatings on the additional layer, and/or to better control the mechanical properties (such as the resonance frequency via a dominant specific mass) of the reed 7. It is also noted that piezoelectric multilayer structures may be applied instead of a single piezoactive layer 4. Note that the resonance frequency of a coupling element, in accordance with the invention, is typically in the GHz range.

For tuning the resonance frequency, a resistive heater layer 5 is arranged on top of the piezoelectric layer 4, separated from the piezoelectric layer 4 by a further insulating layer 3. The resistive heater layer 5 is electrically connected at its left (exposed) end via a rear heater contact area **5A**, and at its right (covered) end via a front end (window) heater contact **5C** reaching through a further insulating oxide layer 3 which separates the metallization 6 from the heater layer 5. The tuning device (heating power supply) is advantageously connected to the heater layer 5 via the rear heater contact area 5A and a metallization contact **5B** in the region of the coupler contact 1 which is electrically connected to the front end heater contact 5C via the metallization 6.

Based on the small mass of the reed 7, the amount of required heating power for providing a deformation is very small. The thermal capacity of the reed 7 is negligible based on the small dimensions of the reed 7 and the fact that the frequency tuning process does not need to be very fast. An eventual bending of the reed 7 due to an unsymmetrical temperature distribution may be compensated by biasing a piezo drive, in the present example the piezo active layer **4**.

The metallization 6 comprises two separated metallization parts (here: stripes), one of which connects the piezoactive layer 4 of the reed 7 to one of the impulse generators IG1..IGn. The other stripe of the metallization 6 connects the heater layer 5 to the heating power supply. By activating the heating supply, the dimensions (in particular the length) of the reed 7 are modified, thus resulting in a change in resonance frequency of the reed 7. The same principle can be carried out with other kinds of coupling elements and/or other types of tuning, e.g. by providing dielectric layers for tuning by electrostriction, or by providing ceramic layers for tuning by photostriction. (In case of photostriction a light source is required, the metallization for the tuning control can be omitted).

The arrangements and methods described above support improved linearity and spectral purity of the RF output signal as well as an improved device yield by a tuneable adjustment of an individual self oscillation frequency of each coupling element, respectively, each sub-array. Additionally, it allows for dynamic compensation of frequency shifts caused by temperature drift or aging effects. Depending on the possible achievable tuning with respect to frequency, an improved broadband or even a certain multiband capability could become feasible, keeping high efficiency, supporting future Software-Defined-Radio, Cognitive Radio or common platform applications. Moreover, the inventive amplifier device principle addresses a wide application range, i.e. highly efficient RF power amplifiers (e.g. radio transmitters in Base Transceiver Stations and user terminal equipment, defence systems, consumer electronic, and the like).

The above description of the preferred embodiments has been given by way of example. From the disclosure given, those skilled in the art will not only understand the present invention and its attendant advantages, but will also find apparent various changes and modifications to the structures and methods disclosed. The applicant seeks, therefore, to cover all such changes and modifications as defined by the appended claims, and equivalents thereof.

### List of reference signs

- 1: coupler contact
- 2: emission layer (coating with material supporting electron emission)
- 3: insulating (oxide) layers
- 4: piezo active layer
- 4A: rear end piezo contact area (pad)
- 4B: metallization contact area (pad) for piezo stimulation
- 4C: front end piezo contact reaching through openings in the underlying layers to the piezo active coating
- 5: heater layer
- 5A: rear heater contact area (pad)
- 5B: metallization contact area (pad) for heater layer
- 5C: front end heater contact reaching through openings (window) in the underlying layers to the heater layer
- 6: metallization for power feeding to front contacts (2 stripes)
- 7: coupler reed
- 8: coupling element
- 10: tuneable RF power amplifier device
- 11: coupling array
- 20: RF power amplifier device
- 21: information about the spectral components of the input signal
- 22: signal processing unit
- 23: feedback path
- 24: reference clock
- 25: antenna network
- 26: digital signal processor
- IG1 - IG_{N}: impulse generators
- SA₁- SA_{N}: sub-arrays
- T₁ - T_{N}: tuning devices
- BS: base station

## Claims

1. Method for providing an amplified RF signal, with the steps of
- analysing the spectral components, namely the amplitudes (c₁...c_{N}) and the phases (φ₁...φ_{N}) at different frequencies (f₁...f_{N}), of an RF signal to be amplified, or a baseband signal to be up-converted to RF and amplified subsequently,
- applying a supply voltage, in particular a dc supply voltage, to a coupling array (11) comprising a plurality of nano-sized coupling elements (8),wherein the coupling elements (8) are grouped into a number N of sub-arrays (SA₁...SA_{N}), with each sub-array (SA₁...SA_{N}) exhibiting
• a specific resonance frequency (f₁...f_{N}), and
• a specific attenuation
of a mechanical self oscillation of its coupling elements (8),
- stimulating mechanical self-oscillations of the coupling elements (8) of the sub-arrays (SA₁...SA_{N}) in dependence of the spectral components of the signal to be amplified, wherein
during and/or prior to the amplification, the resonance frequencies (f₁,..., f_{N}) of the coupling elements (8) of the sub-arrays (SA₁, ..., SA_{N}) are tuned to match the frequency components (f₁...f_{N}) of the signal to be amplified.

2. Method according to claim 1, **characterized in that** the tuning is carried out by preferably reversibly modifying the geometrical dimensions of the coupling elements (8) of the sub-arrays (SA₁, ..., SA_{N}).

3. Method according to claim 2, **characterized in that** the modifying of the geometrical dimensions of the coupling elements (8) is performed by applying an electric field to the coupling elements (8) and/or by irradiating the coupling elements (8) with light and/or by heating the coupling elements (8).

4. Method according to claim 2 or 3, comprising the steps of:
a) feeding back a sample of the amplified RF signal via a feedback path (23),
b) comparing the sample of the amplified RF signal to a desired RF output signal,
c) if a difference between the desired RF output signal and the sample of the amplified RF signal exceeds a pre-defined threshold, modifying the geometrical dimensions of the coupling elements (8) by means of at least one tuning device (T₁,..., T_{N}), and
d) repeating steps a) - c) until the difference between the desired RF output signal and the sample of the amplified RF signal does not exceed the pre-defined threshold.

5. RF power amplifier device (10), comprising
- a coupling array (11) comprising a plurality of nano-sized coupling elements (8) for generating frequency components of an RF output signal,
wherein the coupling elements (8) are grouped into a number N of sub-arrays (SA₁... SA_{N}), with each sub-array (SA₁... SA_{N}) exhibiting
• a specific resonance frequency (f₁... f_{N}) and
• a specific attenuation
of a mechanical self-oscillation of its coupling elements (8),
wherein for the coupling elements (8) of each sub array (SA₁... SA_{N}), there is a stimulating means for stimulating a mechanical self-oscillation,
- and a signal processing unit (22) for controlling the stimulating means with stimulating pulses having a pulse form and timing calculated by the signal processing unit (22) based on an evaluation of the spectral components of a signal to be amplified, namely the amplitudes (c₁...c_{N}) and phases (φ₁...φ_{N}) at the frequencies (f₁...f_{N}) corresponding to said specific resonance frequencies, wherein
tuning devices (T₁...T_{N}) for tuning the resonance frequencies (f₁...f_{N}) of the coupling elements (8) of the sub-arrays (SA₁, ..., SA_{N}) are provided, and wherein the signal processing unit (22) is adapted to control the tuning devices (T₁...T_{N}).

6. RF power amplifier device (10) according to claim 5, **characterized in that** the tuning devices (T₁,...,T_{N}) comprise means for modifying the geometrical dimensions of the coupling elements (8) of the sub-arrays (SA₁, ..., SA_{N}).

7. RF power amplifier device (10) according to claim 6, **characterized in that** at least one, preferably each coupling element (8) of at least one sub-array (SA₁...., SA_{N}) comprises a heater layer (5) and a corresponding tuning device (T₁,...,T_{N}) comprises a heating device for heating the heater layer (5) of the coupling element (8).

8. RF power amplifier device (10) according to claim 6 or 7, **characterized in that** at least one, preferably each coupling element (8) of at least one sub-array (SA₁, ..., SA_{N}) comprises a dielectric layer of electrostrictive material and a corresponding tuning device (T₁,...,T_{N}) comprises means for applying an electric field to the electrostrictive layer of the coupling element (8).

9. RF power amplifier device (10) according to any one of claims 6 to 8, **characterized in that** at least one, preferably each coupling element (8) of at least one sub-array (SA₁, ..., SA_{N}) comprises a layer of photostrictive material and a corresponding tuning device (T₁,...,T_{N}) comprises a light source for irradiating the photostrictive layer of the coupling element (8).

10. RF power amplifier device (10) according to any one of claims 5 to 9, comprising
- a feedback loop (23) for feeding back a sample of the amplified RF signal to the signal processing unit (22), wherein the signal processing unit (22) is adapted to compare the sample of the amplified RF signal to a desired RF output signal, and to modify the geometrical dimensions of the coupling elements (8) for minimizing a difference between the sample of the amplified RF signal and the desired RF output signal.

11. Base station (BS), comprising at least one RF power amplifier device (10) according to any one of claims 5 to 10.

12. Use of an RF power amplifier device (10) according to any one of claims 5 to 10 in a Software Defined Radio platform, a Cognitive Radio platform, or a common platform.

## Patentansprüche

1. Verfahren zur Bereitstellung eines verstärkten Hochfrequenzsignals, die folgenden Schritte umfassend:
- Analysieren der Spektralkomponenten, und zwar der Amplituden (c₁...c_{N}) und der Phasen (φ₁... φ_{N}), bei unterschiedlichen Frequenzen (f₁...f_{N}) eines zu verstärkenden Hochfrequenzsignals, oder eines in die Hochfrequenz aufwärts zu konvertierenden und anschließend zu verstärkenden Basisbandsignals,
- Anlegen einer Versorgungsspannung, insbesondere einer Gleichstrom-Versorgungsspannung, an eine Kopplungsanordnung (11) mit einer Vielzahl von Kopplungselementen (8) in Nanogröße, wobei die Kopplungselemente (8) in eine Anzahl N von Unteranordnungen (SA₁...SA_{N}) gruppiert sind, wobei jede Unteranordnung (SA₁...SA_{N}) aufweist:
• Eine spezifische Resonanzfrequenz (f₁...f_{N}), und
• Eine spezifische Abschwächung
einer mechanischen Eigenschwingung ihrer Kopplungselemente (8),
- Stimulieren von mechanischen Eigenschwingungen der Kopplungselemente (8) der Unteranordnungen (SA₁...SA_{N}) in Abhängigkeit von den Spektralkomponenten des zu verstärkenden Signals, wobei die Resonanzfrequenzen (f₃,..., f_{N}) der Kopplungselemente (8) der Unteranordnungen (SA₁, ..., SA_{N}) während und/oder vor der Verstärkung abgestimmt werden, so dass sie den Frequenzkomponenten (f₁...f_{N}) des zu verstärkenden Signals entsprechen.

2. Verfahren nach Anspruch 1, **dadurch gekennzeichnet, dass** das Abstimmen durch ein vorzugsweise reversibles Modifizieren der geometrischen Abmessungen der Kopplungselemente (8) der Unteranordnungen (SA₁, ..., SA_{N}) erfolgt.

3. Verfahren nach Anspruch 2, **dadurch gekennzeichnet, dass** das Modifizieren der geometrischen Abmessungen der Kopplungselemente (8) durch Anlegen eines elektrischen Feldes an die Kopplungselemente (8) und/oder durch Bestrahlen der Kopplungselemente (8) mit Licht und/oder durch Erwärmen der Kopplungselemente (8) erfolgt.

4. Verfahren nach Anspruch 2 oder 3, die folgenden Schritte umfassend:
a) Rückkoppeln einer Abtastprobe des verstärkten Hochfrequenzsignals über einen Rückkopplungspfad (23),
b) Vergleichen der Abtastprobe des verstärkten Hochfrequenzsignals mit einem gewünschten Hochfrequenzausgangssignal,
c) wenn eine Differenz zwischen dem gewünschten Hochfrequenzausgangssignal und der Abtastprobe des verstärkten Hochfrequenzsignals einen vordefinierten Grenzwert überschreitet, Modifizieren der geometrischen Abmessungen der Kopplungselemente (8) anhand mindestens einer Abstimmvorrichtung (T₁,..., T_{N}), und
d) Wiederholen der Schritte a) - c), bis die Differenz zwischen dem gewünschten Hochfrequenzausgangssignal und der Abtastprobe des verstärkten Hochfrequenzsignals den vordefinierten Grenzwert nicht überschreitet.

5. Hochfrequenz-Leistungsverstärkervorrichtung (10), umfassend:
- eine Kopplungsanordnung (11) mit einer Vielzahl von Kopplungselementen (8) in Nanogröße zum Erzeugen von Frequenzkomponenten eines Hochfrequenzausgangssignals, wobei die Kopplungselemente (8) in eine Anzahl N von Unteranordnungen (SA₁... SA_{N}) gruppiert sind, wobei jede Unteranordung (SA₁...SA_{N}) aufweist:
• Eine spezifische Resonanzfrequenz (f₁...f_{N}), und
• eine spezifische Abschwächung einer mechanischen Eigenschwingung ihrer Kopplungselemente (8),
wobei für die Kopplungselemente (8) einer jeden Unteranordnung (8) (SA₁... SA_{N}) ein Stimuliermittel zum Stimulieren einer mechanischen Eigenschwingung vorgesehen ist,
- und eine Signalverarbeitungseinheit (22) zum Steuern des Stimuliermittels mit Impulsen, deren Impulsform und Zeitplanung durch die Signalverarbeitungseinheit (22) berechnet werden, auf der Basis einer Bewertung der Spektralkomponenten eines zu verstärkenden Signals, und zwar der Amplituden (c₁...c_{N}) und der Phasen (φ₁...φ_{N}) bei den Frequenzen (f₁...f_{N}), welche den besagten Resonanzfrequenzen entsprechen, wobei
Abstimmvorrichtungen (T₁...T_{N}) zum Abstimmen der Resonanzfrequenzen (f₁...f_{N}) der Kopplungselemente (8) der Unteranordnungen (SA₁, ..., SA_{N}) vorgesehen sind, und wobei die Signalverarbeitungseinheit (22) für die Steuerung der Abstimmvorrichtungen (T₁...T_{N}) ausgelegt ist.

6. Hochfrequenz-Leistungsverstärkervorrichtung (10) nach Anspruch 5, **dadurch gekennzeichnet, dass** die Abstimmvorrichtungen (T₁,...,T_{N}) Mittel zum Modifizieren der geometrischen Abmessungen der Kopplungselemente (8) der Unteranordnungen (SA₁, ..., SA_{N}) umfassen.

7. Hochfrequenz-Leistungsverstärkervorrichtung (10) nach Anspruch 6, **dadurch gekennzeichnet, dass** mindestens ein, vorzugsweise jedes Kopplungselement (8) mindestens einer Unteranordnung (SA₁, ..., SA_{N}) eine Heizleiterschicht (5) umfasst, und eine entsprechende Abstimmvorrichtung (T₁,...,T_{N}) eine Heizvorrichtung zum Erwärmen der Heizleiterschicht (5) des Kopplungselements (8) umfasst.

8. Hochfrequenz-Leistungsverstärkervorrichtung (10) nach Anspruch 6 oder 7, **dadurch gekennzeichnet, dass** mindestens ein, vorzugsweise jedes Kopplungselement (8) mindestens einer Unteranordnung (SA₁, ..., SA_{N}) eine dielektrische Schicht aus elektrostriktivem Material umfasst, und eine entsprechende Abstimmvorrichtung (T₁,...,T_{N}) Mittel zum Anlegen eines elektrischen Feldes an die elektrostriktive Schicht des Kopplungselements (8) umfasst.

9. Hochfrequenz-Leistungsverstärkervorrichtung (10) nach einem beliebigen der Ansprüche 6 bis 8, **dadurch gekennzeichnet, dass** mindestens ein, vorzugsweise jedes Kopplungselement (8) mindestens einer Unteranordnung (SA₁, ..., SA_{N}) eine Schicht aus photostriktivem Material umfasst, und eine entsprechende Abstimmvorrichtung (T₁,...,T_{N}) eine Lichtquelle zum Bestrahlen der photostriktiven Schicht des Kopplungselements (8) umfasst.

10. Hochfrequenz-Leistungsverstärkervorrichtung (10) nach einem beliebigen der Ansprüche 5 bis 9, umfassend:
- Eine Rückkopplungsschleife (23) zum Rückkoppeln einer Abtastprobe des verstärkten Hochfrequenzsignals an die Signalverarbeitungseinheit (22), wobei die besagte Signalverarbeitungseinheit (22) dazu ausgelegt ist, das verstärkte Hochfrequenzsignal mit einem gewünschten Hochfrequenz-Ausgangssignal zu vergleichen und die geometrischen Abmessungen der Kopplungselemente (8) zu modifizieren, um eine Differenz zwischen der Abtastprobe des verstärkten Hochfrequenzsignals und dem gewünschten Hochfrequenz-Ausgangssignal zu minimieren.

11. Basisstation (BS), umfassend mindestens eine Hochfrequenz-Leistungsverstärkervorrichtung (10) gemäß einem beliebigen der Ansprüche 5 bis 10.

12. Verwenden einer Hochfrequenz-Leistungsverstärkervorrichtung (10) nach einem beliebigen der Ansprüche 5 bis 10 in einer SDR-Plattform, einer CR-Plattform oder einer gemeinsamen Plattform.

## Revendications

1. Procédé pour fournir un signal RF amplifié, avec les étapes suivantes
- analyser les composantes spectrales, à savoir les amplitudes (c₁... c_{N}) et les phases (φ1...φN) à différentes fréquences (f1...fN), d'un signal RF à amplifier, ou d'un signal de bande de base mis à l'échelle supérieure en RF et à amplifier par la suite,
- appliquer une tension d'alimentation, en particulier une tension d'alimentation CC, à un réseau de couplage (11) comprenant une pluralité d'éléments de couplage nanométriques (8), les éléments de couplage (8) étant groupés en un nombre N de sous-réseaux (SA₁...SA_{N}), chaque sous-réseau (SA₁...SA_{N}) présentant
• une fréquence de résonance spécifique (f₁...f_{N}), et
• une atténuation spécifique
d'une auto-oscillation mécanique de ses éléments de couplage (8),
- stimuler des auto-oscillations mécaniques des éléments de couplage (8) des sous-réseaux (SA₁...SA_{N}) en fonction des composantes spectrales du signal à amplifier, dans lequel
durant et/ou avant l'amplification, les fréquences de résonance (f₁,..., f_{N}) des éléments de couplage (8) des sous-réseaux (SA₁, ..., SA_{N}) sont accordées pour correspondre aux composantes de fréquence (f₁...f_{N}) du signal à amplifier.

2. Procédé selon la revendication 1, **caractérisé en ce que** l'accord est effectué en modifiant de préférence de manière réversible les dimensions géométriques des éléments de couplage (8) des sous-réseaux (SA₁, ..., SA_{N}).

3. Procédé selon la revendication 2, **caractérisé en ce que** la modification des dimensions géométriques des éléments de couplage (8) est effectuée en appliquant un champ électrique aux éléments de couplage (8) et/ou en irradiant les éléments de couplage (8) avec de la lumière et/ou en chauffant les éléments de couplage (8).

4. Procédé selon la revendication 2 ou 3, comprenant les étapes suivantes :
e) renvoyer un échantillon du signal RF amplifié par l'intermédiaire d'un trajet de rétroaction (23),
f) comparer l'échantillon du signal RF amplifié à un signal de sortie RF souhaité,
g) si une différence entre le signal de sortie RF souhaité et l'échantillon du signal RF amplifié dépasse un seuil prédéfini, modifier les dimensions géométriques des éléments de couplage (8) au moyen d'au moins un dispositif d'accord (T₁,..., T_{N}), et
h) répéter les étapes a) à c) jusqu'à ce que la différence entre le signal de sortie RF souhaité et l'échantillon du signal RF amplifié ne dépasse pas le seuil prédéfini.

5. Dispositif amplificateur de puissance RF (10), comprenant
- un réseau de couplage (11) comprenant une pluralité d'éléments de couplage nanométriques (8) pour générer des composantes de fréquence d'un signal de sortie RF,
dans lequel les éléments de couplage (8) sont regroupés en un nombre N de sous-réseaux (SA₁,..SA_{N}), chaque sous-réseau (SA₁..,SA_{N}) présentant
• une fréquence de résonance spécifique (f₁...f_{N}), et
• une atténuation spécifique
d'une auto-oscillation mécanique de ses éléments de couplage (8),
dans lequel pour les éléments de couplage (8) de chaque sous-réseau (SA₁...SA_{N}), il existe un moyen de stimulation destiné à stimuler une auto-oscillation mécanique,
- et une unité de traitement de signaux (22) pour commander les moyens de stimulation avec des impulsions de stimulation présentant une forme d'impulsion et un accord calculés par l'unité de traitement de signaux (22) sur la base d'une évaluation des composantes spectrales d'un signal à amplifier, à savoir les amplitudes (c₁...c_{N}) et les phases (φ₁...φ_{N}) aux fréquences (f₁...f_{N}) correspondant auxdites fréquences de résonance spécifiques, dans lequel des dispositifs d'accord (T₁...T_{N}) pour accorder les fréquences de résonance (f₁...f_{N}) des éléments de couplage (8) des sous-réseaux (SA₁, ..., SA_{N}) sont fournis, et dans lequel l'unité de traitement de signaux (22) est adaptée pour commander les dispositifs d'accord (T₁...T_{N}).

6. Dispositif amplificateur de puissance RF (10) selon la revendication 5, **caractérisé en ce que** les dispositifs d'accord (T₁...T_{N}) comprennent des moyens pour modifier les dimensions géométriques des éléments de couplage (8) des sous-réseaux (SA₁, ..., SA_{N}).

7. Dispositif amplificateur de puissance RF (10) selon la revendication 6, **caractérisé en ce que** au moins un, de préférence chaque, élément de couplage (8) d'au moins un sous-réseau (SA₁, ..., SA_{N}) comprend une couche de chauffage (5) et un dispositif d'accord correspondant (T₁,...,T_{N}) comprend un dispositif de chauffage pour chauffer la couche de chauffage (5) de l'élément de couplage (8).

8. Dispositif amplificateur de puissance RF (10) selon la revendication 6 ou 7, **caractérisé en ce que** au moins un, de préférence chaque, élément de couplage (8) d'au moins un sous-réseau (SA₁, ..., SA_{N}) comprend une couche diélectrique de matériau électrostrictif et un dispositif d'accord correspondant (T₁,...,T_{N}) comprend des moyens pour appliquer un champ électrique sur la couche électrostrictive de l'élément de couplage (8).

9. Dispositif amplificateur de puissance RF (10) selon l'une quelconque des revendications 6 à 8, **caractérisé en ce que** au moins un, de préférence chaque, élément de couplage (8) d'au moins un sous-réseau (SA₁, ... , SA_{N}) comprend une couche de matériau photostrictif et un dispositif d'accord correspondant (T₁,...,T_{N}) comprend une source de lumière pour irradier la couche photostrictive de l'élément de couplage (8).

10. Dispositif amplificateur de puissance RF (10) selon l'une quelconque des revendications 5 à 9, comprenant
- une boucle de rétroaction (23) pour renvoyer un échantillon du signal RF amplifié à l'unité de traitement de signaux (22), dans lequel l'unité de traitement de signaux (22) est adaptée pour comparer l'échantillon du signal RF amplifié à un signal de sortie RF souhaité, et pour modifier les dimensions géométriques des éléments de couplage (8) pour réduire au minimum une différence entre l'échantillon du signal RF amplifié et le signal de sortie RF souhaité.

11. Station de base (BS), comprenant au moins un dispositif amplificateur de puissance RF (10) selon l'une quelconque des revendications 5 à 10.

12. Utilisation d'un dispositif amplificateur de puissance RF (10) selon l'une quelconque des revendications 5 à 10 dans une plate-forme RRL, une plate-forme RI, ou une plate-forme commune.
